# EUROPEAN PATENT APPLICATION

(11) **EP 4 750 256 A1**
(43) Date of publication of application: **27.05.2026**
(21) Application number: 25205361.6
(22) Date of filing: 29.09.2025
(51) Int. Cl.: H10D 30/67, H10D 86/40

(54) **THIN FILM TRANSISTOR SUBSTRATE, MANUFACTURING METHOD THEREOF, AND DISPLAY APPARATUS COMPRISING THE SAME**

(30) Priority: 25.11.2024 KR 20240169835
(71) Applicant: LG Display Co., Ltd., Seoul, 07336 (KR)
(72) Inventor: LEE, Sohyung, 10845 Gyeonggi-do (KR); JI, Hyelim, 10845 Gyeonggi-do (KR); CHOI, Soyang, 10845 Gyeonggi-do (KR); KIM, SungKi, 10845 Gyeonggi-do (KR); KIM, DaeHwan, 10845 Gyeonggi-do (KR)
(74) Representative: Morrall, Jonathan Ian McLachlan

(57) **Abstract**

The present invention provides a display apparatus comprising a thin film transistor substrate and manufacturing method thereof, the display apparatus comprising: a base substrate; and a first thin film transistor and a second thin film transistor disposed on the base substrate and spaced apart from each other, wherein the first thin film transistor includes: a first oxide semiconductor layer; and a first gate electrode overlapping the first oxide semiconductor layer, and the second thin film transistor includes: a second oxide semiconductor layer; and a second gate electrode overlapping the second oxide semiconductor layer, wherein the first oxide semiconductor layer includes a first sub-oxide semiconductor layer having a crystalline structure, and the second oxide semiconductor layer has a first amorphous structure.

## Description

### CROSS-REFERENCE TO RELATED APPLICATIONS

This application claims the benefit of priority of the Korean Patent Application No. 10-2024-0169835 filed on November 25, 2024, which is hereby incorporated by reference as if fully set forth herein.

### Field

The present invention relates to a thin film transistor substrate, a method for manufacturing the same, and a display apparatus including the same.

### Discussion of the Related Art

Since thin film transistors can be manufactured on glass or plastic substrates, they are widely used as switching elements or driving elements in display apparatuses such as liquid crystal display apparatuses or organic light emitting devices.

Thin film transistors can be classified into amorphous silicon thin film transistors in which amorphous silicon is used as the active layer, polycrystalline silicon thin film transistors in which polycrystalline silicon is used as the active layer, and oxide semiconductor thin film transistors in which oxide semiconductor is used as the active layer, based on the material constituting the active layer.

There is a method of making oxide semiconductors into crystalline structures to improve reliability and at the same time enhance mobility by preventing physical and chemical damage or defects that cause deterioration of oxide semiconductor thin film transistors.

Recently, research has been continuously conducted on methods to selectively form specific oxide semiconductor thin film transistors into a crystalline structure.

### SUMMARY

One example of the present invention is to provide a thin film transistor substrate having both a crystalline structure and an amorphous structure due to selective laser irradiation.

Another example of the present invention is to provide a thin film transistor substrate having improved device reliability by forming a partially crystallization region.

Another example of the present invention is to provide a thin film transistor substrate having improved process efficiency due to selective laser irradiation.

Another example of the present invention is to provide a method for manufacturing such a thin film transistor substrate.

Another example of the present invention is to provide a display apparatus including such a thin film transistor substrate.

In order to achieve these and other aspects of the present disclosure, one example of the present invention provides a thin film transistor substrate comprising: a base substrate; and a first thin film transistor and a second thin film transistor disposed on the base substrate and spaced apart from each other, wherein the first thin film transistor includes: a first oxide semiconductor layer; and a first gate electrode overlapping the first oxide semiconductor layer, and the second thin film transistor includes: a second oxide semiconductor layer; and a second gate electrode overlapping the second oxide semiconductor layer, wherein the first oxide semiconductor layer includes a first sub-oxide semiconductor layer having a crystalline structure, and the second oxide semiconductor layer has a first amorphous structure.

The crystalline structure has a first crystal grains having a grain size of 1 nm or more in a cross-sectional image, the first amorphous structure has a second crystal grains having a grain size of 1 nm or more in a cross-sectional image, a proportion of the first crystal grains may be 50% or more of the total cross-sectional area of the first sub-oxide semiconductor layer, and a proportion of the second crystal grains may be 3% or less of the total cross-sectional area of the second oxide semiconductor layer.

The first oxide semiconductor layer is made of a first oxide semiconductor material having a mobility of 10 cm²/Vs or less, the first oxide semiconductor layer further includes a second sub-oxide semiconductor layer, the first sub-oxide semiconductor layer is disposed on the second sub-oxide semiconductor layer, and the second sub-oxide semiconductor layer can have a second amorphous structure different from the first amorphous structure.

The first sub-oxide semiconductor layer and the second sub-oxide semiconductor layer are made of the same material, and the thickness of the first sub-oxide semiconductor layer may be greater than or equal to the thickness of the second sub-oxide semiconductor layer.

The second amorphous structure has third crystal grains having a grain size of 1 nm or more in a cross-sectional image, and the proportion of the third crystal grains may be 5% to 20% of the total cross-sectional area of the second sub-oxide semiconductor layer.

The first oxide semiconductor layer is formed of a second oxide semiconductor material, and the first oxide semiconductor layer can be formed of a crystalline structure.

The mobility of the first oxide semiconductor material is 10 cm²/Vs or less, and the first oxide semiconductor material may include at least one of an IZO (InZnO)-based oxide semiconductor material having an In concentration of less than 50% relative to the total concentration of In and Zn on an atomic basis, an IGZO (InGaZnO)-based oxide semiconductor material having an In concentration of less than 33% relative to the total concentration of In, Ga, and Zn, an IGZTO (InGaZnSnO)-based oxide semiconductor material having a sum of concentrations of In and Sn of less than 45% relative to the total concentration of In, Ga, Zn, and Sn, a GZTO (GaZnSnO)-based oxide semiconductor material, and a GZO (GaZnO)-based oxide semiconductor material.

The mobility of the second oxide semiconductor material is 10 cm²/Vs exceeds, and the second oxide semiconductor material may include at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 33% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having a sum of concentrations of In and Sn of 45% or more relative to the total concentration of In, Ga, Zn, and Sn, and an ITZO (InSnZnO)-based oxide semiconductor material having a sum of concentrations of In and Sn of 45% or more relative to the total concentration of In, Sn, and Zn.

The first sub-oxide semiconductor layer may have at least one of a (400) crystal plane, a (222) crystal plane, a (220) crystal plane, a (311) crystal plane, and a (0016) crystal plane.

Another example of the present invention provides a method for manufacturing a thin film transistor substrate, comprising the steps of: preparing a base substrate disposed in a first region and a second region; forming a first oxide semiconductor layer on the base substrate disposed in the first region and forming a second oxide semiconductor layer on the base substrate disposed in the second region; and forming a first gate electrode and a second gate electrode to overlap the first oxide semiconductor layer and the second oxide semiconductor layer, respectively, wherein the step of forming the first oxide semiconductor layer and the second oxide semiconductor layer comprises: forming an oxide semiconductor material layer on the base substrate; selectively irradiating a laser to the oxide semiconductor material layer disposed in the first region to crystallize the oxide semiconductor material layer disposed in the first region; forming a photoresist material layer on the oxide semiconductor material layer; and wet-etching the oxide semiconductor material layer using the photoresist material layer, wherein the first oxide semiconductor layer includes a first sub-oxide semiconductor layer having a crystalline structure, and the second oxide semiconductor layer having a first amorphous structure.

The laser may not be irradiated to the oxide semiconductor material layer disposed in the second region.

The crystalline structure has first crystal grains having a grain size of 1 nm or more in a cross-sectional image, the first amorphous structure has second crystal grains having a grain size of 1 nm or more in a cross-sectional image, the proportion of the first crystal grains may be 50% or more of the total cross-sectional area of the first sub-oxide semiconductor layer, and the proportion of the second crystal grains may be 3% or less of the total cross-sectional area of the second oxide semiconductor layer.

When the oxide semiconductor material layer is made of a first oxide semiconductor material, and a mobility of the first oxide semiconductor material is 10 cm²/Vs or less, the first oxide semiconductor layer further includes a second sub-oxide semiconductor layer, the first sub-oxide semiconductor layer is disposed on the second sub-oxide semiconductor layer, and the second sub-oxide semiconductor layer can have a second amorphous structure different from the first amorphous structure.

The second amorphous structure has third crystal grains having a grain size of 1 nm or more in a cross-sectional image, and the proportion of the third crystal grains may be 5% to 20% of the total cross-sectional area of the second sub-oxide semiconductor layer.

When the oxide semiconductor material layer is formed of a second oxide semiconductor material, and a mobility of the second oxide semiconductor material exceeds 10 cm²/Vs, the first oxide semiconductor layer can be formed of the crystalline structure.

Another example of the present invention can provide a display apparatus including a thin film transistor substrate.

The display apparatus further includes a gate driver having a plurality of stages each driving a plurality of gate lines and pixel driving circuit, wherein each of the plurality of stages includes an output unit including a pull-up transistor supplying a clock signal as an output voltage in response to the control of a first node, wherein the first thin film transistor may be the pull-up transistor, and the second thin film transistor may be included in the gate driver or the pixel driving circuit.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a cross-sectional view of a thin film transistor substrate according to one example of the disclosure.
FIG. 2 is a cross-sectional view of a thin film transistor substrate according to another example of the disclosure.
FIG. 3A is a cross-sectional view of a thin film transistor substrate according to another example of the disclosure.
FIG. 3B is a cross-sectional view of a thin film transistor substrate according to another example of the disclosure.
FIGS. 4A to 4J are process diagrams showing a manufacturing process of a thin film transistor substrate according to another example of the disclosure.
FIG. 5 is a schematic diagram of a display apparatus according to another example of the disclosure.
FIG. 6 is a schematic diagram of a shift register.
FIG. 7 is a circuit diagram of one example of a stage provided in the shift register of FIG. 6.
Fig. 8 is a circuit diagram for one pixel P of Fig. 5.

### DETAILED DESCRIPTION OF THE DISCLOSURE

Advantages and features of the present disclosure and implementation methods thereof will be clarified through following examples described with reference to the accompanying drawings. The present disclosure may, however, be embodied in different forms and should not be construed as limited to the examples set forth herein. Rather, these examples are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing examples of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted.

In a case where 'comprise', 'have' and 'include' described in the present disclosure are used, another portion may be added unless 'only~' is used. The terms of a singular form may include plural forms unless referred to the contrary.

In construing an element, the element is construed as including an error band although there is no explicit description.

In describing a position relationship, for example, when the position relationship is described as 'upon~', 'above~', 'below~' and 'next to~', one or more portions may be disposed between two other portions unless 'just' or 'direct' is used.

Spatially relative terms such as "below", "beneath", "lower", "above", and "upper" may be used herein to easily describe a relationship of one element or elements to another element or elements as illustrated in the drawings. It will be understood that these terms are intended to encompass different orientations of the device in addition to the orientation depicted in the drawings. For example, if the device illustrated in the figure is reversed, the device described to be arranged "below", or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various examples of the present disclosure may be partially or overall coupled to or combined with each other and may be variously inter-operated with each other and driven technically as those skilled in the art can sufficiently understand. The examples of the present disclosure may be carried out independently from each other or may be carried out together in a co-dependent relationship.

In the addition of reference numerals to the components of each drawing describing examples of the present disclosure, the same components can have the same sign as can be displayed on the other drawings.

In the examples of the present disclosure, a source electrode and a drain electrode are distinguished for convenience of description, and the source electrode and the drain electrode may be interchanged. The source electrode may be the drain electrode and vice versa. In addition, the source electrode of any one example may be a drain electrode in another example, and the drain electrode of any one example may be a source electrode in another example.

In some examples of the present disclosure, for convenience of description, a source area is distinguished from a source electrode, and a drain area is distinguished from a drain electrode, but examples of the present disclosure are not limited thereto. The source area may be the source electrode, and the drain area may be the drain electrode. In addition, the source area may be the drain electrode, and the drain area may be the source electrode.

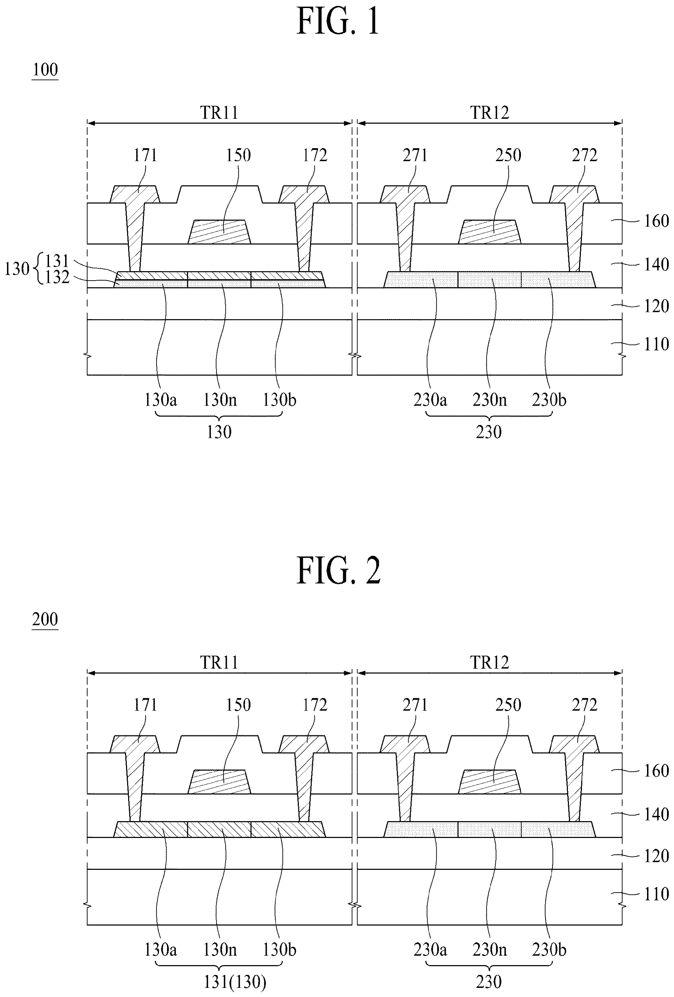

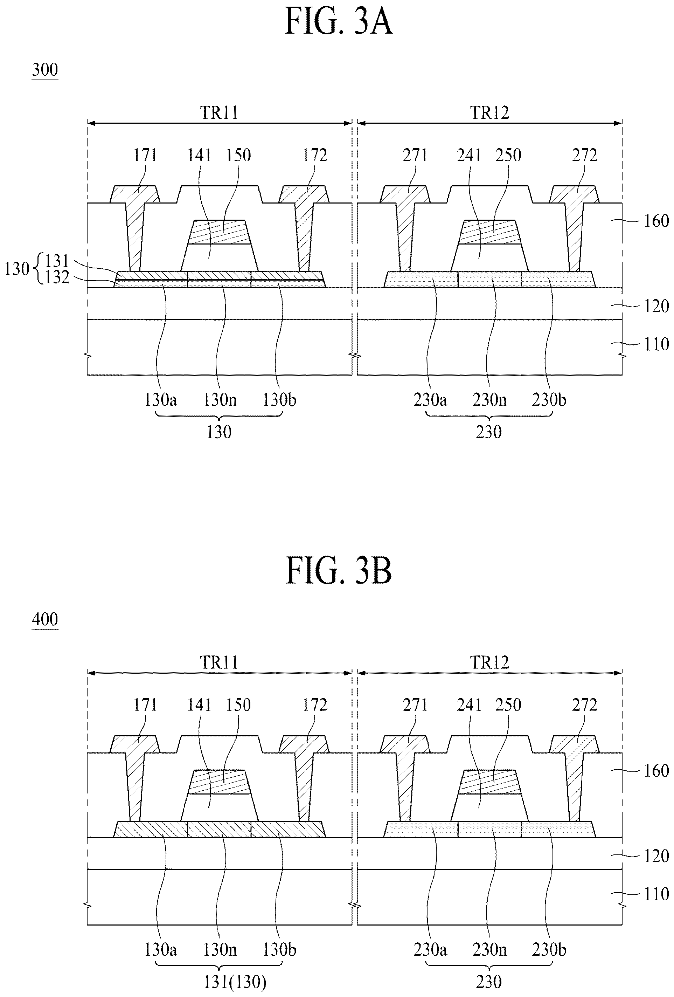

FIG. 1 is a cross-sectional view of a thin film transistor substrate 100 according to one example of the present invention. FIG. 2 is a cross-sectional view of a thin film transistor substrate 200 according to one example of the present invention. FIG. 3A is a cross-sectional view of a thin film transistor substrate 300 according to one example of the present invention. FIG. 3B is a cross-sectional view of a thin film transistor substrate 400 according to one example of the present invention.

A thin film transistor substrate 100 according to one example of the present invention includes a base substrate 110 and a first thin film transistor TR11 and a second thin film transistor TR12 disposed on the base substrate 110 and spaced apart from each other.

The first thin film transistor TR11 according to one example of the present invention includes a first oxide semiconductor layer 130 and a first gate electrode 150. A second thin film transistor TR12 includes a second oxide semiconductor layer 230 and a second gate electrode 250.

The components of the base substrate, the first thin film transistor TR11, and the second thin film transistor TR12 are described in detail below.

Glass or plastic may be used as the base substrate 110. A transparent plastic having flexible properties, such as polyimide, may be used as the plastic. The first thin film transistor TR11 and the second thin film transistor TR12 are disposed on the base substrate 110.

A light-blocking layer (not shown) may be disposed on the base substrate 110. The light-blocking layer (not shown) blocks light incident from the base substrate 110 and protects the first oxide semiconductor layer 130 and the second oxide semiconductor layer 230. If another structure serves as a light blocking structure, the light-blocking layer (not shown) may be omitted.

According to one example of the present invention, a buffer layer 120 may be disposed on a base substrate 110.

The buffer layer 120 has insulating properties and protects the first oxide semiconductor layer 130 and the second oxide semiconductor layer 230. The buffer layer 120 may include at least one of silicon oxide (SiOx), silicon nitride (SiNx), and metal oxide having insulating properties.

In FIG. 1, the buffer layer 120 is illustrated as a single layer, but one example of the present invention is not limited thereto and may be a plurality of layers. In addition, another layer may be disposed between the base substrate 110 and the buffer layer 120, and another layer may be disposed between the buffer layer 120 and the first oxide semiconductor layer 130 and the second oxide semiconductor layer 230.

According to one example of the present invention, the first oxide semiconductor layer 130 and the second oxide semiconductor layer 230 are each disposed on the buffer layer 120.

According to one example of the present invention, the first oxide semiconductor layer 130 and the second oxide semiconductor layer 230 may include an oxide semiconductor material.

The first oxide semiconductor layer 130 includes a channel portion 130n, a first connection portion 130a, and a second connection portion 130b. The second oxide semiconductor layer 230 includes a channel portion 230n, a first connection portion 230a, and a second connection portion 230b.

The channel portions 130n, 230n overlap with the first gate electrode 150 and the second gate electrode 250, respectively. The first connection portion 130a, 230a is disposed on one side of the channel portion 130n, 230n. The second connection portion 130b, 230b is disposed on the other side of the channel portion 130n, 230n. The channel portions 130n, 230n are disposed between the first connection portion 130a, 230a and the second connection portion 130b, 230b. The first connection portion 130a, 230a and the second connection portion 130b, 230b do not overlap with the first gate electrode 150 and the second gate electrode 250, respectively.

For example, the first oxide semiconductor layer 130 may be made of a first oxide semiconductor material and may be made of a second oxide semiconductor material. For example, the first oxide semiconductor layer 130 may be made of a high-mobility material and may be made of a low-mobility material.

According to one example of the present invention, at least a portion of the first oxide semiconductor layer 130 may have a crystalline structure. In addition, the second oxide semiconductor layer 230 may have a first amorphous structure. Specifically, the second oxide semiconductor layer 230 may be formed of the first amorphous structure. For example, the first oxide semiconductor layer 130 may include a first sub-oxide semiconductor layer 131 having a crystalline structure.

According to one example of the present invention, the first oxide semiconductor layer 130 of the first thin film transistor TR11 can be selectively irradiated by a laser. The irradiation may only be applied to the first oxide semiconductor layer. For example, the first oxide semiconductor layer 130 is selectively irradiated, at least a portion of the first oxide semiconductor layer 130 may have a crystalline structure. The second oxide semiconductor layer 230 is not irradiated with the laser, and thus may not have a crystalline structure. For example, the second oxide semiconductor layer 230 may be formed of a first amorphous structure.

According to one example of the present invention, the degree of crystallization of the first oxide semiconductor layer 130 may vary depending on the material of the first oxide semiconductor layer 130.

For example, when the first oxide semiconductor layer 130 has a mobility of 10 cm²/Vs or less, and the laser is selectively irradiated only to the first oxide semiconductor layer 130, the first oxide semiconductor layer 130 may have a multilayer structure. That is to say that the irradiation penetrates to a depth that creates a multilayer structure in the first oxide semiconductor layer.

For example, the first oxide semiconductor material may include at least one of an IZO (InZnO)-based oxide semiconductor material having an In concentration of less than 50% relative to the total concentration of In and Zn on an atomic basis, an IGZO (InGaZnO)-based oxide semiconductor material having an In concentration of less than 33% relative to the total concentration of In, Ga, and Zn, an IGZTO (InGaZnSnO)-based oxide semiconductor material having a sum of concentration of In and Sn of less than 45% relative to the total concentration of In, Ga, Zn, and Sn, a GZTO (GaZnSnO)-based oxide semiconductor material, and a GZO (GaZnO)-based oxide semiconductor material.

For example, in the case of the IZO (InZnO)-based, the ratio of In and Zn can be between 2:8 to 4:6 and preferably 4:6, 3:7, or 2:8.

When the concentration of In is 50% or more relative to the total concentration of In and Zn in the IZO (InZnO)-based, or when the concentration of In is 33% or more relative to the total concentration of In, Ga, and Zn in the IGZO (InGaZnO)-based, or when the sum of the concentrations of In and Sn is 45% or more relative to the total concentration of In, Ga, Zn, and Sn in the IGZTO (InGaZnSnO)-based, the concentration of indium (In) in the first oxide semiconductor layer 130 increases, so that the entire first oxide semiconductor layer 130 can have a complete crystal structure.

For example, the first oxide semiconductor layer 130 may include a second sub-oxide semiconductor layer 132 having a second amorphous structure and a first sub-oxide semiconductor layer 131 having a crystalline structure and disposed on the second sub-oxide semiconductor layer 132. According to the present invention, the second amorphous structure is different from the first amorphous structure.

FIG. 1 illustrates a first oxide semiconductor layer 130 composed of a first sub-oxide semiconductor layer 131 and a second sub-oxide semiconductor layer 132.

At this time, the first sub-oxide semiconductor layer 131 and the second sub-oxide semiconductor layer 132 may be made of the same material. Since the first sub-oxide semiconductor layer 131 and the second sub-oxide semiconductor layer 132 are made of the same material and have a multilayer structure, the process efficiency may be improved becausethe multilayer structure can be formed by the irradiating laser from a single layer. The multilayer structure does not need to be formed from a first layer and a second layer added by a by a sputtering process. For example, if the first oxide semiconductor layer 130 forms a multilayer structure using different materials (for example by sputtering) and the upper part of the first oxide semiconductor layer 130 is crystallized, there may be a problem of reduced process efficiency.

According to one example of the present invention, the thickness of the first sub-oxide semiconductor layer 131 may be greater than or equal to the thickness of the second sub-oxide semiconductor layer 132.

At this time, if the thickness of the first sub-oxide semiconductor layer 131 is less than 50% compared to the total thickness of the first oxide semiconductor layer 130, the first oxide semiconductor layer 130 may not have a sufficient crystalline structure, and thus the first oxide semiconductor layer 130 may not have excellent resistance to defects. As a result, the first thin film transistor TR11 including the first oxide semiconductor layer 130 may not have excellent current characteristics and reliability.

According to one example of the present invention, the crystalline structure, the first amorphous structure, and the second amorphous structure are distinguished from each other based on the content of crystal grains included in the oxide semiconductor layer. More specifically, according to one example of the present invention, the crystalline structure, the first amorphous structure, and the second amorphous structure are distinguished from each other based on the ratio of crystal grains having a grain size of 1 nm or more.

According to one example of the present invention, a crystal grain is defined as a collection of atoms having a regular arrangement. Atoms have a regular arrangement within a crystal grain. A lump having atoms within a regular arrangement can also be defined as a crystal grain.

According to one example of the present invention, the arrangement state of atoms can be confirmed by a cross-sectional image captured by a transmission electron microscope (TEM). A cross-sectional image of an oxide semiconductor layer can be obtained by a transmission electron microscope (TEM), and in the cross-sectional image of the oxide semiconductor layer, crystal grains have a single aggregate or two-dimensional lump shape having a boundary.

The crystal grain has a grain size. In a cross-sectional image taken by a transmission electron microscope (TEM), the length of the longest axis of a crystal grain is called the grain size.

According to one example of the present invention, in a cross-sectional image of an oxide semiconductor layer captured by a transmission electron microscope (TEM), if a proportion of first crystal grains having a grain size of 1 nm or more is 50% or more of the total cross-sectional area of the layer, the oxide semiconductor layer is defined to have a crystalline structure. In addition, in a cross-sectional image of the oxide semiconductor layer captured by a transmission electron microscope (TEM), if a proportion of second crystal grains having a grain size of 1 nm or more is 3% or less of the total cross-sectional area of the layer, the oxide semiconductor layer is defined to have a first amorphous structure. In addition, in a cross-sectional image of the oxide semiconductor layer captured by a transmission electron microscope (TEM), if a proportion of third crystal grains having a grain size of 1 nm or more is 5% to 20% of the total cross-sectional area of the layer, the oxide semiconductor layer is defined to have a second amorphous structure.

For example, in the cross-sectional image, the second oxide semiconductor layer 230 may have a ratio of second crystal grains having a grain size of 1 nm or more of 3% or less of the total cross-sectional area of the layer. In the cross-sectional image, the second sub-oxide semiconductor layer 132 may have a ratio of third crystal grains having a grain size of 1 nm or more of 5% to 20% of the total cross-sectional area of the layer. For example, in the cross-sectional image, the first sub-oxide semiconductor layer 131 may have a ratio of first crystal grains having a grain size of 1 nm or more of 50% or more of the total cross-sectional area of the layer. More specifically, in the cross-sectional image, the first sub-oxide semiconductor layer 131 may have a ratio of crystal grains having a grain size of 5 nm to 10 nm of 50% or more of the total cross-sectional area of the layer.

Preferably, the ratio of the second crystal grains in the first amorphous structure is close to 0%, but some crystal grain characteristics may be exhibited due to an imbalance in plasma dissociation during the deposition process of the second oxide semiconductor layer 230. The imbalance in plasma dissociation refers to a phenomenon in which the plasma is not uniformly dissociated and ionized throughout the chamber due to non-uniformities such as power intensity during plasma treatment or the oxygen concentration in the chamber. As a result, the active layer may exhibit partial crystal grain characteristics (about 3%) even without undergoing a separate crystallization process.

In addition, when the second sub-oxide semiconductor layer 132 is irradiated with a laser, it is covered by the first sub-oxide semiconductor layer 131 and maintained in an amorphous state, but since the defects in the film are partially offset by the heat generated by the laser irradiation, there is a high possibility that structural deformation due to heat energy in a subsequent process may occur. Therefore, the ratio of the third crystal grains in the second sub-oxide semiconductor layer 132 may be higher than the ratio of the second crystal grains in the second oxide semiconductor layer 230. Preferably, the second sub-oxide semiconductor layer 132 may have a ratio of the third crystal grains having a particle size of 1 nm or more in a cross-sectional image of 5% to 10% of the total cross-sectional area.

For example, the first sub-oxide semiconductor layer 131 has a crystalline structure, and this crystalline structure may have first crystal grains having a grain size of 1 nm or more in a cross-sectional image. For example, the second oxide semiconductor layer 230 has a first amorphous structure, and this first amorphous structure may have second crystal grains having a grain size of 1 nm or more in a cross-sectional image. In addition, the second sub-oxide semiconductor layer 132 has a second amorphous structure, and this second amorphous structure may have third crystal grains having a grain size of 1 nm or more in a cross-sectional image. The proportion of the first crystal grains may be 50% or more of the total cross-sectional area of the first sub-oxide semiconductor layer 131, the proportion of the second crystal grains may be 3% or less of the total cross-sectional area of the second oxide semiconductor layer 230, and the proportion of the third crystal grains may be 5% to 20% of the total cross-sectional area of the second sub-oxide semiconductor layer 132.

According to one example of the present invention, a dopant may be doped into the first oxide semiconductor layer 130. For example, the dopant may be included in a target material during a sputtering process for forming the first oxide semiconductor layer (130). Accordingly, according to one example of the present invention, the first oxide semiconductor layer 130 may further include a dopant doped into the oxide semiconductor material. The dopant may include, for example, at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge). Specifically, the first oxide semiconductor layer 130 may be formed of an IGO (InGaO)-based oxide semiconductor material doped with at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge).

Dopants can be disposed within crystal grains or at boundaries between crystal grains. Even if a dopant is included within a collection of atoms, if other atoms other than the dopant are regularly disposed within the collection of atoms, the collection of atoms is called a crystal grain.

When a dopant is doped into the first oxide semiconductor layer 130, defects in the grains of the first oxide semiconductor layer 130 can be prevented, so that the first oxide semiconductor layer 130 can have a stable crystal structure, and crystal grains having a grain size of 1 nm or more can be easily formed in the first oxide semiconductor layer 130. When at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge) is doped into the first oxide semiconductor layer 130 made of an oxide semiconductor material, crystal grains can be easily formed in the first oxide semiconductor layer 130. Specifically, due to the dopant having a high bonding strength with oxygen (O), which is a constituent element of the oxide semiconductor material, the first oxide semiconductor layer 130 can have a stable crystal structure, and crystal grains having a grain size of 1 nm or more can be easily formed in the first oxide semiconductor layer 130. As a result, the first oxide semiconductor layer 130 can have excellent resistance to defects.

According to one example of the present invention, the dopants beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge) can act as crystallization stabilizers that control the crystallization conditions, grain size, or crystallization state of the first oxide semiconductor layer 130. In addition, the dopants having metal characteristics can act as electrical stabilizers that control changes in the electrical characteristics of the first oxide semiconductor layer 130. Specifically, beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge) doped into the oxide semiconductor material can control the effective formation of crystal grains in the first oxide semiconductor layer 130, and also can ensure that the electrical characteristics of the first oxide semiconductor layer 130 are stably maintained.

The dopant included in the first oxide semiconductor layer 130 may have a content of 0.1 to 10 atomic% based on the total number of atoms of the first oxide semiconductor layer 130. Specifically, the dopant included in the first oxide semiconductor layer 130 may have a content of 0.1 to 10 atomic% based on the total number of atoms of the first oxide semiconductor layer 130.

When the dopant included in the first oxide semiconductor layer 130 has a content of less than 0.1 atomic% based on the total number of atoms of the first oxide semiconductor layer 130, a problem occurs in which it cannot function as a crystallization stabilizer that controls crystallization conditions, crystal grain size, or crystallization state.

In addition, when the dopant included in the first oxide semiconductor layer 130 has a content exceeding 10 atomic% based on the total number of atoms of the first oxide semiconductor layer 130, the activation energy required for crystallization of the first oxide semiconductor layer 130 may increase, and the dopant included in the first oxide semiconductor layer 130 may interfere with the lattice arrangement, making it difficult for the oxide semiconductor layer to have a complete lattice arrangement, making it difficult to secure crystallinity, or may cause a problem of amorphization. As a result, the oxide semiconductor may not have characteristics as a semiconductor, and the electrical characteristics may deteriorate.

According to one example of the present invention, the first sub-oxide semiconductor layer 131 can serve as a main channel layer of the first oxide semiconductor layer 130.

According to one example of the present invention, the first sub-oxide semiconductor layer 131 may have at least one of a (400) crystal plane, a (222) crystal plane, a (220) crystal plane, a (311) crystal plane, and a (0016) crystal plane. In a case where the first sub-oxide semiconductor layer 131 is formed of a first oxide semiconductor material having a mobility of 10 cm²/V·s or less, the first sub-oxide semiconductor layer 131 may have a CAAC (c-axis aligned crystalline) structure. In contrast, when the first sub-oxide semiconductor layer 131 is formed of a second oxide semiconductor material having a mobility greater than 10 cm²/V·s, the first sub-oxide semiconductor layer 131 may have at least one of a (400) crystal plane, a (222) crystal plane, a (220) crystal plane, a (311) crystal plane, and a (0016) crystal plane.

In the first sub-oxide semiconductor layer 131 having a crystalline structure, defects in grains are prevented, thereby preventing defects or damage during the manufacturing process or operation. As a result, the first oxide semiconductor layer 130 can have excellent reliability. The first thin film transistor TR1 including the first oxide semiconductor layer 130 can have excellent reliability characteristics due to a reduction in defects, and at the same time, can have an effect of increasing mobility.

According to one example of the present invention, when the first oxide semiconductor layer 130 is made of a second oxide semiconductor material having a mobility exceeding 10 cm²/Vs and a laser is selectively irradiated only to the first oxide semiconductor layer 130, the first oxide semiconductor layer 130 may have a single-layer structure. For example, the first oxide semiconductor layer 130 may be a single-layer formed of a crystalline structure.

For example, the second oxide semiconductor material may include at least one of an IZO (InZnO)-based oxide semiconductor material having an In concentration of 50% or more relative to the total concentration of In and Zn, an IGO (InGaO)-based oxide semiconductor material having an In concentration of 70% or more relative to the total concentration of In and Ga, an IGZO (InGaZnO)-based oxide semiconductor material having an In concentration of 33% or more relative to the total concentration of In, Ga, and Zn, an ITO (InSnO)-based oxide semiconductor material having an In concentration of 80% or more relative to the total concentration of In and Sn, an IGZTO (InGaZnSnO)-based oxide semiconductor material having a sum of concentrations of In and Sn of 45% or more relative to the total concentration of In, Ga, Zn, and Sn, and an ITZO (InSnZnO)-based oxide semiconductor material having a sum of concentrations of In and Sn of 45% or more relative to the total concentration of In, Sn, and Zn

For example, in the case of the IZO (InZnO)-based, the ratio of In and Zn can be between 5:5 to 7:3 and preferably 5:5, 6:4, or 7:3.

When the concentration of In is less than 50% relative to the total concentration of In and Zn in the IZO (InZnO)-based, or when the concentration of In is less than 70% relative to the total concentration of In and Ga in the IGO (InGaO)-based, or when the concentration of In is less than 33% relative to the total concentration of In, Ga, and Zn in the IGZO (InGaZnO)-based, or when the concentration of In is less than 80% relative to the total concentration of In and Sn in the ITO (InSnO)-based, or when the sum of the concentrations of In and Sn is less than 45% relative to the total concentration of In, Ga, Zn, and Sn in the IGZTO (InGaZnSnO)-based, or when the sum of the concentrations of In and Sn is less than 45% relative to the total concentration of In, Sn, and Zn in the ITZO (InSnZnO)-based, the concentration of indium (In) in the first oxide semiconductor layer 130 may be low, so that only a portion of the first oxide semiconductor layer 130 may have an intact crystal structure.

Referring to FIG. 2, the first oxide semiconductor layer 130 may be formed of a crystalline structure. For example, the first oxide semiconductor layer 130 may not have an amorphous structure.

The higher the mobility of an oxide semiconductor material, the more oxygen vacancies (Vo). When the same energy is applied to a first oxide semiconductor material, which is a low-mobility material, and a second oxide semiconductor material, which is a high-mobility material, the more oxygen vacancies (Vo) there are, the more efficient element rearrangement occurs within the oxide semiconductor material. In other words, the higher the mobility of the material, the better the crystallization of the oxide semiconductor layer occurs.

According to one example of the present invention, a gate insulating film 140 is disposed on a first oxide semiconductor layer 130 and a second oxide semiconductor layer 230. Specifically, the gate insulating film 140 is disposed between the first oxide semiconductor layer 130 and the first gate electrode 150 and between the second oxide semiconductor layer 230 and the second gate electrode 250.

According to one example of the present invention, the gate insulating film 140 can cover the entire upper surfaces of the first oxide semiconductor layer 130 and the second oxide semiconductor layer 230. FIG. 1 illustrates a state in which the gate insulating film 140 covers the entire upper surfaces of the first oxide semiconductor layer 130 and the second oxide semiconductor layer 230.

However, the present invention is not limited thereto, and the gate insulating film 140 may expose a portion of each of the first oxide semiconductor layer 130 and the second oxide semiconductor layer 230. For example, the gate insulating film 140 may be formed by being patterned. For example, FIGS. 3A and 3B illustrate a first gate insulating film 141 and a second gate insulating film 241 being patterned and disposed on the first oxide semiconductor layer 130 and the second oxide semiconductor layer 230, respectively.

The gate insulating film 140 may include at least one of silicon oxide, silicon nitride, and metal oxide. The gate insulating film 140 may have a single film structure or a multilayer film structure. The gate insulating film 140 protects the first oxide semiconductor layer 130 and the second oxide semiconductor layer 230.

According to one example of the present invention, a first gate electrode 150 and a second gate electrode 250 may be disposed on a gate insulating film 140.

According to one example of the present invention, the first gate electrode 150 and the second gate electrode 250 may overlap the first oxide semiconductor layer 130 and the second oxide semiconductor layer 230. For example, referring to FIG. 1, the first gate electrode 150 may overlap the first oxide semiconductor layer 130, and the second gate electrode 250 may overlap the second oxide semiconductor layer 230.

The first gate electrode 150 and the second gate electrode 250 may each include at least one of an aluminum series metal such as aluminum (Al) or an aluminum alloy, a silver series metal such as silver (Ag) or a silver alloy, a copper series metal such as copper (Cu) or a copper alloy, a molybdenum series metal such as molybdenum (Mo) or a molybdenum alloy, chromium (Cr), tantalum (Ta), neodymium (Nd), and titanium (Ti). The first gate electrode 150 and the second gate electrode 250 may each have a multilayer film structure including at least two conductive films having different physical properties.

An interlayer insulating film 160 is disposed on the first gate electrode 150 and the second gate electrode 250. The interlayer insulating film 160 is an insulating layer made of an insulating material. Specifically, the interlayer insulating film 160 may be made of an organic material, an inorganic material, or a laminate of an organic material layer and an inorganic material layer.

A first source electrode 171, a first drain electrode 172, a second source electrode 271, and a second drain electrode 272 are disposed on an interlayer insulating film 160. The first source electrode 171 and the first drain electrode 172 are spaced apart from each other and are respectively connected to a first oxide semiconductor layer 130. The first source electrode 171 and the first drain electrode 172 are respectively connected to a first connecting portion 130a and a second connecting portion 130b of the first oxide semiconductor layer 130 through contact holes formed in the interlayer insulating film 160. The second source electrode 271 and the second drain electrode 272 are respectively connected to a first connecting portion 230a and a second connecting portion 230b of the second oxide semiconductor layer 230 through contact holes formed in the interlayer insulating film 160.

The first source electrode 171, the first drain electrode 172, the second source electrode 271, and the second drain electrode 272 may each include at least one of molybdenum (Mo), aluminum (Al), chromium (Cr), gold (Au), titanium (Ti), nickel (Ni), neodymium (Nd), copper (Cu), and alloys thereof. The first source electrode 171, the first drain electrode 172, the second source electrode 271, and the second drain electrode 272 may each be formed of a single layer made of a metal or an alloy of metals, or may be formed of a multilayer of two or more layers.

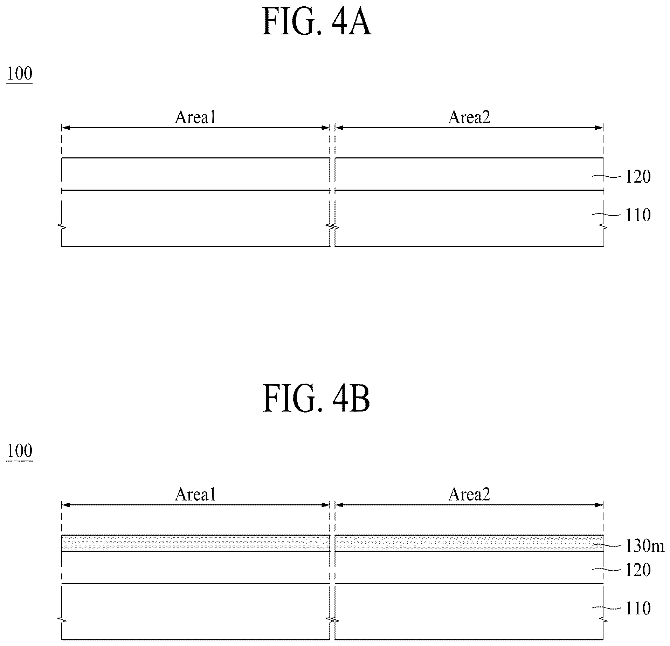

FIGs 4A to 4J are manufacturing process diagrams of a thin film transistor substrate 100 according to another example of the present invention. The details of the configuration already described above are omitted.

Referring to FIG. 4A, a base substrate 110 disposed in a first area Area1 and a second area Area2 may be prepared, and a buffer layer 120 may be formed on the base substrate 110. The buffer layer 120 may be formed over the entire upper surface of the base substrate 110. The first area Area1 and the second area Area2 are disposed spaced apart from each other.

Referring to FIG. 4B, an oxide semiconductor material layer 130m can be formed on the buffer layer 120. The oxide semiconductor material layer 130m is formed over the entire upper surface of the buffer layer 120. The oxide semiconductor material layer 130m can be formed of a first oxide semiconductor material having a mobility of 10 cm²/Vs or less, or can be formed of a second oxide semiconductor material having a mobility of more than 10 cm²/Vs. In addition, the present invention is not limited thereto, and oxide semiconductor materials having different mobilities can be formed in the first area Area1 and the second area Area2. FIGS. 4B to 4J illustrate a case where the oxide semiconductor material layer 130m is formed of a first oxide semiconductor material having a mobility of 10 cm²/Vs or less.

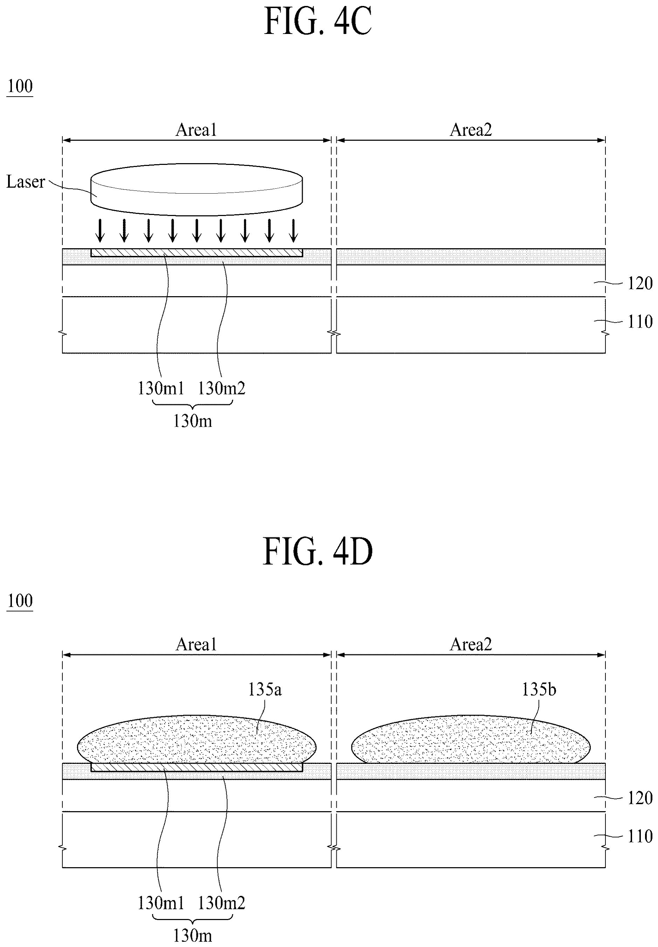

Referring to FIG. 4C, a laser is selectively irradiated to an oxide semiconductor material layer 130m disposed in a first area Area1 to crystallize the oxide semiconductor material layer 130m disposed in the first area Area1. At this time, a YAG laser can be used as the laser. The laser can be performed using a light source that irradiates light in a relatively short wavelength range of less than 500 nm. The laser is irradiated only to the first area Area1 and not to the second area Area2.

By selectively irradiating the laser, the oxide semiconductor material layer 130m can be formed of a non-crystallized second oxide semiconductor material layer 130m2 and a crystallized first oxide semiconductor material layer 130m1. Specifically, in the first area Area1, the oxide semiconductor material layer 130m can be formed of a two-layer structure of the first oxide semiconductor material layer 130m1 and the second oxide semiconductor material layer 130m2, and in the second area Area2, the oxide semiconductor material layer 130m can be formed of a second oxide semiconductor material layer 130m2 having an amorphous structure.

At this time, the first oxide semiconductor material layer 130m1 irradiated with a laser in the first area Area1 may have a crystalline structure having a first crystal grain, an area of the second oxide semiconductor material layer 130m2 that does not overlap with the first oxide semiconductor material layer 130m1 may have a first amorphous structure having a second crystal grain, and an area of the second oxide semiconductor material layer 130m2 that overlaps with the first oxide semiconductor material layer 130m1 may have a second amorphous structure having a third crystal grain. An explanation thereof is omitted because it overlaps with the preceding content.

However, when the oxide semiconductor material layer 130m is formed of a second oxide semiconductor material having a mobility exceeding 10 cm²/Vs, the oxide semiconductor material layer 130m may be formed of a single layer structure having a crystalline structure in the first area Area1 where the laser is irradiated, and the oxide semiconductor material layer 130m may be formed of a second oxide semiconductor material layer 130m2 having an amorphous structure in the second area Area2 where the laser is not irradiated.

Referring to FIG. 4D, photoresist material layers 135a, 135b can be formed on the oxide semiconductor material layer 130m. Specifically, photoresist material layers 135a, 135b can be formed on each of the first area Area1 and the second area Area2. For example, in the first area Area1, the photoresist material layer 135a can cover the entire upper surface of the first oxide semiconductor material layer 130m1.

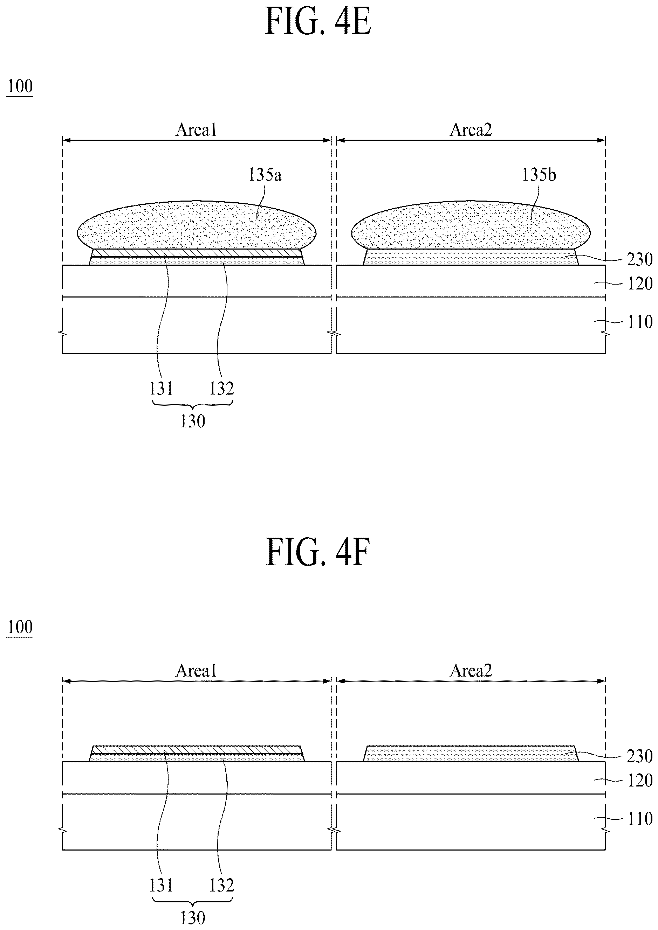

Referring to FIG. 4E, the oxide semiconductor material layer 130m can be wet-etched using the photoresist material layers 135a, 135b. The first oxide semiconductor layer 130 and the second oxide semiconductor layer 230 can be formed through the wet etching. At this time, the first oxide semiconductor layer 130 can be formed of a second sub-oxide semiconductor layer 132 having an amorphous structure and a first sub-oxide semiconductor layer 131 having a crystalline structure, which is disposed on the second sub-oxide semiconductor layer 132.

Referring to FIG. 4F, the photoresist material layer 135a, 135b can be removed.

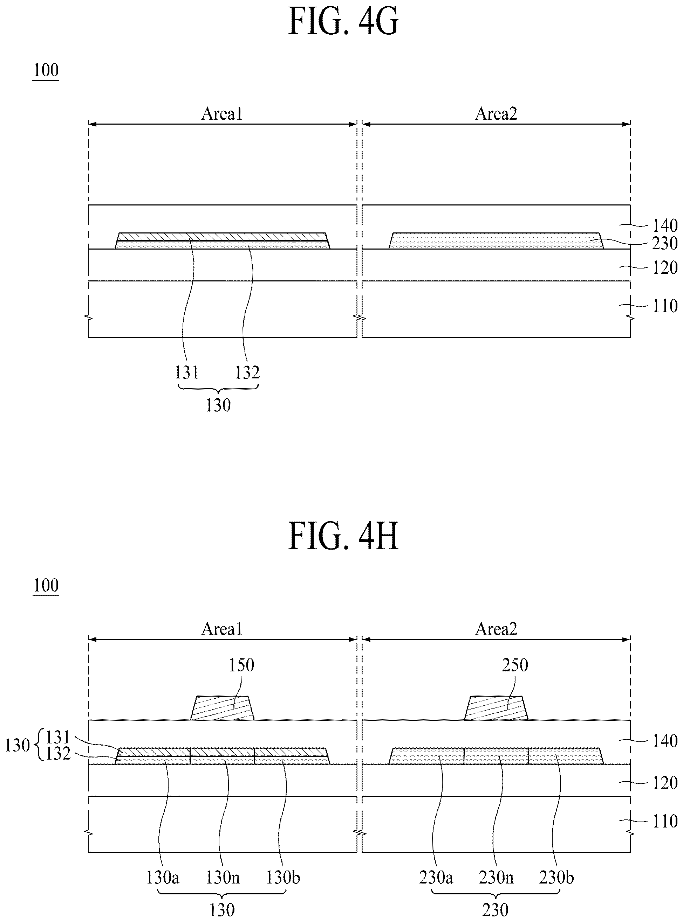

Referring to FIG. 4G, a gate insulating film 140 can be formed on the first oxide semiconductor layer 130 and the second oxide semiconductor layer 230. The description of the gate insulating film 140 is omitted as it overlaps with the previous content.

Referring to FIG. 4H, a first gate electrode 150 and a second gate electrode 250 can be formed on a gate insulating film 140. The first gate electrode 150 and the second gate electrode 250 can overlap the first oxide semiconductor layer 130 and the second oxide semiconductor layer 230, respectively. Descriptions of the first gate electrode 150 and the second gate electrode 250 are omitted because they overlap with the preceding content.

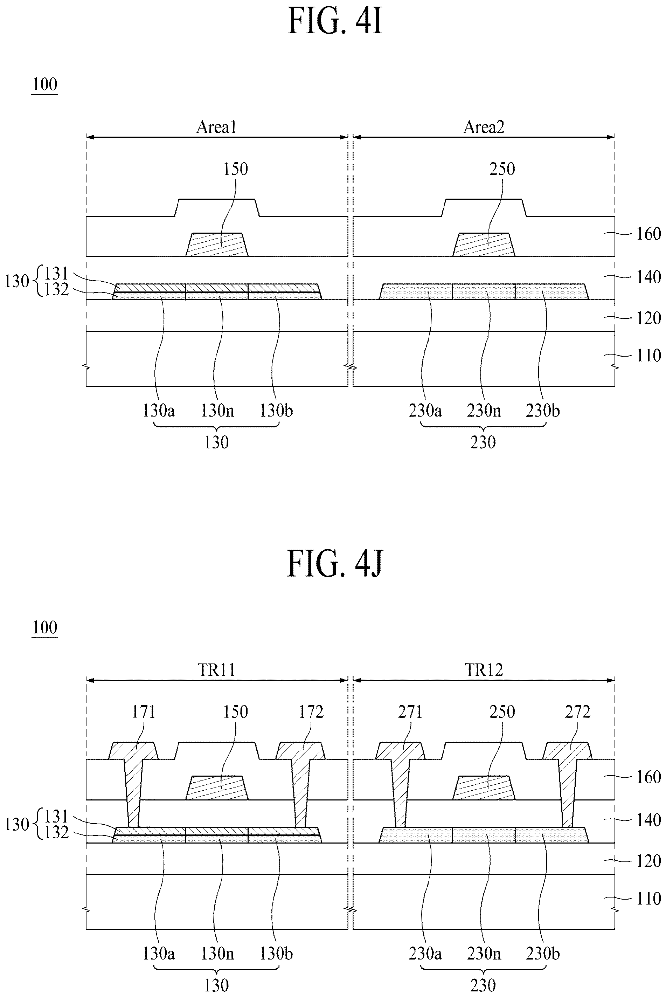

Referring to FIG. 4I, an interlayer insulating film 160 can be formed on the first gate electrode 150 and the second gate electrode 250. The description of the interlayer insulating film 160 is omitted as it overlaps with the previous content.

Referring to FIG. 4J, a first source electrode 171, a first drain electrode 172, a second source electrode 271, and a second drain electrode 272 can be formed on an interlayer insulating film 160. Descriptions of the first source electrode 171, the first drain electrode 172, the second source electrode 271, and the second drain electrode 272 are omitted as they overlap with the preceding content.

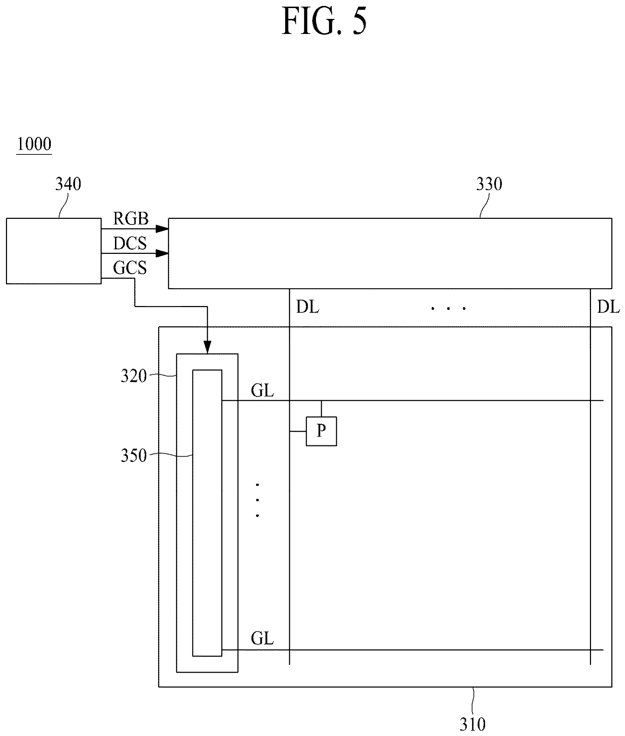

FIG. 5 is a schematic diagram illustrating a display apparatus 1000 according to further still another example of the present disclosure.

As shown in FIG. 5, the display apparatus 1000 according to further still another example of the present disclosure may include a display panel 310, a gate driver 320, a data driver 330 and a controller 340.

The display panel 310 includes gate lines GL and data lines DL, and pixels P are disposed in intersection areas of the gate lines GL and the data lines DL. An image is displayed by driving of the pixels P. The gate lines GL, the data lines DL and the pixels P may be disposed on the base substrate 110.

The controller 340 controls the gate driver 320 and the data driver 330.

The controller 340 outputs a gate control signal GCS for controlling the gate driver 320 and a data control signal DCS for controlling the data driver 330 by using a signal supplied from an external system not shown. Also, the controller 340 samples input image data input from the external system, realigns the sampled data and supplies the realigned digital image data RGB to the data driver 330.

The gate control signal GCS includes a gate start pulse GSP, a gate shift clock GSC, a gate output enable signal GOE, a start signal Vst and a gate clock GCLK. Also, control signals for controlling a shift register may be included in the gate control signal GCS.

The data control signal DCS includes a source start pulse SSP, a source shift clock signal SSC, a source output enable signal SOE and a polarity control signal POL.

The data driver 330 supplies a data voltage to the data lines DL of the display panel 310. In detail, the data driver 330 converts the image data RGB input from the controller 340 into an analog data voltage and supplies the data voltage to the data lines DL.

According to one example of the present disclosure, the gate driver 320 may be packaged on the display panel 310. In this way, a structure in which the gate driver 320 is directly packaged on the display panel 310 will be referred to as a Gate In Panel (GIP) structure. In detail, in the Gate In Panel (GIP) structure, the gate driver 320 may be disposed on the base substrate 110.

The display apparatus 1000 according to one example of the present disclosure may include the above-described thin film transistor substrate 100, 200, and 300. According to one example of the present disclosure, the gate driver 320 may include the above-described thin film transistor substrate 100, 200, and 300.

The gate driver 320 may include a shift register 350.

The shift register 350 sequentially supplies gate pulses to the gate lines GL for one frame by using the start signal and the gate clock, which are transmitted from the controller 340. In this case, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

The shift register 350 may include the above-described thin film transistor substrate 100, 200, and 300.

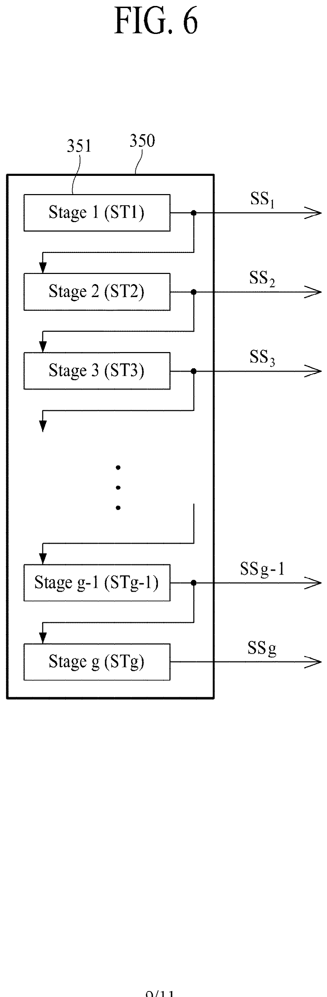

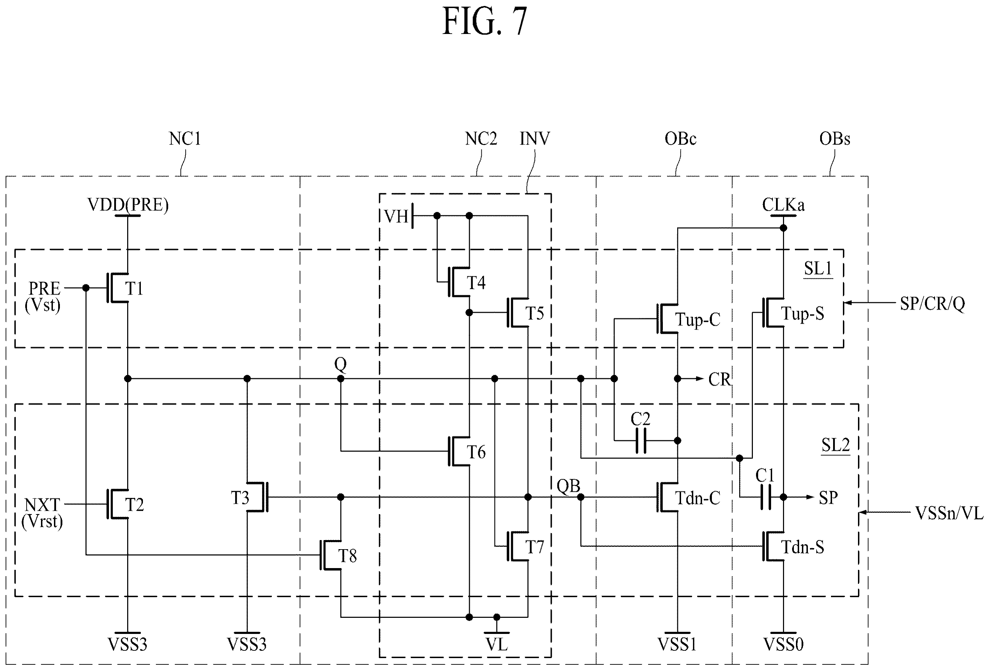

FIG. 6 is a schematic diagram illustrating a shift register 350. FIG. 7 is a circuit diagram of the stage 351 provided in the shift register 350 of FIG. 6.

Referring to FIG. 6, the shift register 350 may include a plurality of stages driving a plurality of gate lines. For example, the shift register 350 may include g number of stages 351 (ST1 to STg).

The shift register 350 transmits one scan signal SS to pixels P connected to one gate line GL through one gate line GL. Each of the stages 351 may be connected to one gate line GL. When g number of gate lines GL are formed in the display panel 110, the shift register 350 may include g number of stages 351 (ST1 to STg), and may generate g number of scan signals SS1 to SSg.

In general, each stage 351 outputs the gate pulse GP once during one frame, and the gate pulses GP are sequentially output from each stage 351.

FIG. 7 is a circuit diagram showing a stage 351 of a shift register 350 of the gate driver 320.

One stage 351 of the shift register shown in FIG. 7 includes output units OBc and OBs for supplying an output voltage Vout in response to the logical state of the first node Q, and a first node control unit NC1 for controlling charging and discharging of the first node Q.

The output units OBc and OBs include a pull-up transistor Tup that supplies a clock signal CLKa as an output voltage in response to the control of the first node. The output voltage is supplied to the corresponding gate line as a scan pulse and as a carry signal that controls charging and discharging of other stages.

The first node control unit NC1 includes a first transistor T1 of a set unit for charging the first node Q with the high potential voltage VDD or the front output PRE in response to the front output PRE from the previous stage, and a second transistor T2 of the reset unit for discharging the first node Q with the low potential voltage VSS, which is a reset voltage, in response to the rear output NXT from the next stage. When the stage 351 of FIG. 7 is the first stage ST, a start pulse Vst is supplied instead of the front output PRE.

When the stage 351 of FIG. 7 is the last stage, the reset pulse Vrst is supplied instead of the rear output NXT.

In the first period, the first node Q is pre-charged by the turned-on first transistor T1 in response to the front-end output PRE or the start pulse Vst, and then floated in a charged state by the first and second transistors T1 and T2 turned off in the second period. In this case, the gate-on voltage (gate high voltage) of the clock signal CLKa is supplied to the drain electrode of the pull-up transistor Tup and the voltage of the first node Q is amplified by the capacitor between the gate electrode and the source electrode of the pull-up transistor Tup, so that the pull-up transistor Tup is stably turned on to output the gate-on voltage of the clock signal CLKa as an output voltage.

Subsequently, in the third period, the pull-up transistor Tup maintaining the turn-on state by floating the first node Q outputs the gate-off voltage (gate low voltage) of the clock signal CLKa as an output voltage.

Then, in the fourth period, the first node Q is discharged by the second transistor T2 turned on in response to the rear output NXT or the reset pulse Vrst, and the pull-up transistor Tup is turned off, so that the output voltage maintains the gate-off voltage.

Referring to FIG. 7, since the carry output unit OBc controlled by the first node Q1 is provided, the output units OBc and OBs are divided into a scan output unit OBs and a carry output unit OBc.

The scan output unit OBc includes a scan pull-up transistor Tup-S that outputs the clock pulse CLKa as the scan pulse SP in response to the control of the first node Q. The carry output unit OBc includes a carry pull-up transistor Tup-C that outputs the clock pulse CLKa as a carry signal CR in response to the control of the first node Q. The carry signal CR output from the carry output unit OBc is supplied as a front-end output PRE for the rear stage and is supplied as a rear-end output NXT for the front-end stage. Accordingly, the output node of the carry signal CR and the output node of the scan signal SP are separated to reduce the load of the carry signal CR, thereby reducing the delay of the carry signal CR that controls charging and discharging of the front and rear stages.

According to one example of the present invention, the first thin film transistor TR11 of the thin film transistor substrate 100, 200, 300 according to the present invention may be used as the pull-up transistor Tup. Specifically, the first thin film transistor TR11 of the thin film transistor substrate 100, 200, 300 according to the present invention may be used as the carry pull-up transistor Tup-C and the scan pull-up transistor Tup-S.

Specifically, the carry pull-up transistor Tup-C and the scan pull-up transistor Tup-S need to have improved current characteristics and reliability in order to stably output the carry signal CR and the scan signal SP. That is, in order for the carry pull-up transistor Tup-C and the scan pull-up transistor Tup-S to have excellent current characteristics and reliability, the first thin film transistor TR11 of the thin film transistor substrate 100, 200, 300 according to the present invention needs to be used.

Referring to FIG. 7, a carry pull-down transistor Tdn-C in which the carry output unit OBc is controlled by the second node QB is additionally provided, a scan pull-down transistor Tdn-S in which the scan output unit OBs is controlled by the second node QB is additionally provided, and a second node control unit NC2 including an inverter INV connected between the first node Q and the second node QB is additionally provided.

The scan pull-down transistor Tdn-S of the scan output unit OBs supplies the first low potential voltage VSS0 as the first gate-off voltage of the scan signal SP in response to the control of the second node QB.

The carry pull-down transistor Tdn-C of the carry output unit OBc supplies the second low potential voltage VSS1 as the second gate-off voltage of the carry signal CR in response to the control of the second node QB. The carry signal CR output from the carry output unit OBc is supplied as a front-end output PRE for the rear stage and is supplied as a rear-end output NXT for the front-end stage. In the first node control unit NC1, the second transistor T2, which is a reset part, discharges the first node Q to a third low potential voltage VSS2, which is a reset voltage in response to the rear-end carry signal CRn.

The inverter INV of the second node control unit NC2 supplies a high potential voltage VH or a low potential voltage VL opposite to the voltage of the first node Q to the second node QB in response to the control of the first node Q.

The high potential voltages VDD and VH may be the same as or different from each other. The low potential voltages VSS0, VSS1, VSS2, and VL may be the same as or different from each other.

In addition, the first node control unit NC1 further includes a third transistor T3 of the noise cleaner controlled by the second node QB, the second node control unit NC2 includes an inverter INV composed of fourth to seventh transistors T4 to T7, and further includes an eighth transistor T8 controlled by the shear output PRE. A third low potential voltage VSS2, which is a second reset voltage, is applied to the third transistor T3 of the noise cleaner, and a fourth low potential voltage VSS3, which is a first reset voltage, is applied to the second transistor T2 of the reset unit.

The third transistor T3 of the noise cleaner added to the first node control unit NC1 discharges the first node Q to the third low potential voltage VSS2 in response to the control of the second node QB. Accordingly, when the first node Q is a low logic, the third transistor T3 removes noise induced to the first node Q by the coupling of the clock CLKa supplied to the pull-up transistor Tup-C and Tup-S. The inverter INV of the second node control unit NC2 includes fourth to seventh transistors T4, T5, T6, and T7 to supply a high potential voltage VH or a low potential voltage VL to the second node QB so as to be opposite to the voltage of the first node Q. The eighth transistor T8 added to the second node control unit NC2 discharges the second node QB to a low potential voltage VL in response to the previous output PRE.

A first capacitor C1 for amplifying the voltage of the gate electrode Q is formed between the gate electrode and the source electrode of the scan pull-up transistor Tup-S of the scan output unit OBs. A second capacitor C2 for amplifying the voltage of the gate electrode Q is formed between the gate electrode and the source electrode of the carry pull-up transistor Tup-C of the carry output unit OBc.

When the first node Q is in a charged state by the first node control unit NC1, the scan and carry pull-up transistors Tup-S and Tup-C output the clock signal CLKa as a scan signal SP and a carry signal CR, respectively.

When the second node QB is in a charged state by the second node control unit NC2, the scan and carry pull-down transistors Tdn-S and Tdn-C output the first and second low potential voltages VSS0 and VSS1 as a scan signal SP and a carry signal CR, respectively.

According to one example of the present invention, among the transistors provided in the stage 351, excluding the pull-up transistor Tup, the second thin film transistor TR12 of the thin film transistor substrate 100, 200, 300 according to the present invention can be used as the transistor T1, T2, T3, T4, T5, T6, T7, Tdn.

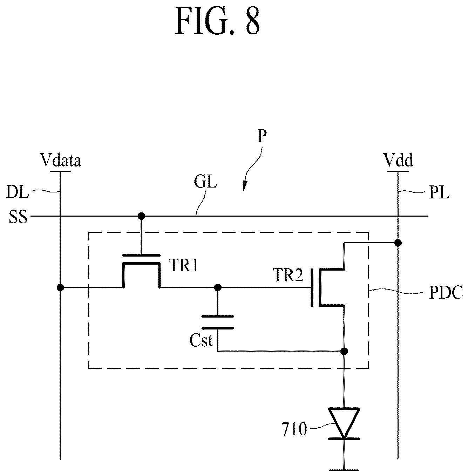

FIG. 8 is a circuit view illustrating any one pixel P of FIG. 5.

The circuit view of FIG. 8 is an equivalent circuit view for the pixel P of the display apparatus 1000 that includes an organic light emitting diode OLED as a display device 710.

Referring to FIG. 8, the pixel P includes a display device 710 and a pixel driving circuit PDC for driving the display device 710. In detail, the display apparatus 1000 according to one example of the present disclosure may include a pixel driving circuit PDC on the base substrate 110.

The pixel driving circuit PDC of FIG. 8 includes a switching transistor and a driving transistor.

According to another example of the present invention, the second thin film transistor TR12 of the thin film transistor substrate 100, 200, 300 described above can be used as a switching transistor or a driving transistor.

The second thin film transistor TR2, which is a driving transistor, is connected to the display device 710. The first thin film transistor TR1, which is a switching transistor, is connected to the gate line GL and the data line DL and is turned on or off by the scan signal SS supplied through the gate line GL.

The data line DL provides the data voltage Vdata to the pixel driving circuit PDC, and the first thin film transistor TR1 controls application of the data voltage Vdata.

The driving power line PL provides a driving voltage Vdd to the display device 710, and the second thin film transistor TR2, which is a driving transistor, controls the driving voltage Vdd. The driving voltage Vdd is a pixel driving voltage for driving the organic light emitting diode OLED that is the display device 710.

When the second thin film transistor TR2 is turned on by the scan signal SS applied through the gate line GL from the gate driver 320, the data voltage Vdata supplied through the data line DL is supplied to the gate electrode of the second thin film transistor TR2 connected to the display device 710. The data voltage Vdata is charged in the storage capacitor Cst formed between the gate electrode and the source electrode of the second thin film transistor TR2.

According to the data voltage Vdata, the amount of current supplied to the organic light emitting diode OLED that is the display device 710 through the second thin film transistor TR2 is controlled, and accordingly, the gray level of light output from the display device 710 may be controlled.

According to the present disclosure, the following advantageous effects may be obtained.

A thin film transistor substrate according to one example of the present invention can have improved device reliability due to selective laser irradiation.

A thin film transistor substrate according to another example of the present invention can have improved process efficiency due to selective laser irradiation.

In addition to the effects mentioned above, other features and advantages of the present invention may be clearly understood by those skilled in the art to which the present invention pertains from the above description and explanation.

It will be apparent to those skilled in the art that the present disclosure described above is not limited by the above-described examples and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.

Further disclosed are the following numbered clauses:
1. A display apparatus including a thin film transistor substrate, the thin film transistor substrate comprising:
   a base substrate; and
   a first thin film transistor (TR11) and a second thin film transistor (TR12) disposed on the base substrate and spaced apart from each other,
   wherein the first thin film transistor includes:
      a first oxide semiconductor layer; and
      a first gate electrode overlapping the first oxide semiconductor layer, and
   the second thin film transistor includes:
      a second oxide semiconductor layer; and
      a second gate electrode overlapping the second oxide semiconductor layer,
      wherein the first oxide semiconductor layer includes a first sub-oxide semiconductor layer having a crystalline structure, and
      wherein the second oxide semiconductor layer has a first amorphous structure.
2. The display apparatus of clause 1, wherein the crystalline structure has first crystal grains having a grain size of 1 nm or more in a cross-sectional image,
   wherein the first amorphous structure has second crystal grains having a grain size of 1 nm or more in a cross-sectional image,
   wherein a proportion of the first crystal grains is 50% or more of a total cross-sectional area of the first sub-oxide semiconductor layer, and
   wherein a proportion of the second crystal grains is 3% or less of a total cross-sectional area of the second oxide semiconductor layer.
3. The display apparatus of clause 1 or 2, wherein the first oxide semiconductor layer is made of a first oxide semiconductor material,
   wherein the first oxide semiconductor layer further includes a second sub-oxide semiconductor layer,
   wherein the first sub-oxide semiconductor layer is disposed on the second sub-oxide semiconductor layer, and
   wherein the second sub-oxide semiconductor layer has a second amorphous structure different from the first amorphous structure.
4. The display apparatus of clause 3, wherein the first sub-oxide semiconductor layer and the second sub-oxide semiconductor layer are made of the same material, and a thickness of the first sub-oxide semiconductor layer is greater than or equal to the thickness of the second sub-oxide semiconductor layer.
5. The display apparatus of clause 3 or 4, wherein the second amorphous structure has third crystal grains having a grain size of 1 nm or more in a cross-sectional image, and a proportion of the third crystal grains is 5% to 20% of a total cross-sectional area of the second sub-oxide semiconductor layer.
6. The display apparatus of any preceding clause, wherein the first oxide semiconductor layer is formed of a second oxide semiconductor material, and the first oxide semiconductor layer is formed of a crystalline structure, and optionally wherein the first oxide semiconductor layer is a single-layer.
7. The display apparatus of any one of clauses 3 to 6, wherein a mobility of the first oxide semiconductor material is 10 cm²/Vs or less.
8 The display apparatus of clause 7, wherein the first oxide semiconductor material includes at least one of an IZO-based oxide semiconductor material having an In concentration of less than 50% relative to a total concentration of In and Zn on an atomic basis, an IGZO-based oxide semiconductor material having an In concentration of less than 33% relative to a total concentration of In, Ga, and Zn, an IGZTO-based oxide semiconductor material having a sum of concentrations of In and Sn of less than 45% relative to a total concentration of In, Ga, Zn, and Sn, a GZTO-based oxide semiconductor material, and a GZO-based oxide semiconductor material.
9 The display apparatus of clause 8 when the first oxide semiconductor material includes an IZO-based oxide semiconductor material having an In concentration of less than 50% relative to a total concentration of In and Zn on an atomic basis, the ratio of In and Zn is between 2:8 to 4:6 and preferably wherein the ratio is 4:6, 3:7, or 2:8.
10. The display apparatus of any of clauses 6 to 9, wherein a mobility of the second oxide semiconductor material exceeds 10 cm²/Vs.
11. The display apparatus of clause 10, wherein the second oxide semiconductor material includes at least one of an IZO-based oxide semiconductor material having an In concentration of 50% or more relative to a total concentration of In and Zn, an IGO-based oxide semiconductor material having an In concentration of 70% or more relative to a total concentration of In and Ga, an IGZO-based oxide semiconductor material having an In concentration of 33% or more relative to a total concentration of In, Ga, and Zn, an ITO-based oxide semiconductor material having an In concentration of 80% or more relative to a total concentration of In and Sn, an IGZTO-based oxide semiconductor material having a sum of concentrations of In and Sn of 45% or more relative to a total concentration of In, Ga, Zn, and Sn, and an ITZO-based oxide semiconductor material having a sum of concentrations of In and Sn of 45% or more relative to a total concentration of In, Sn, and Zn.
12. The display apparatus of clause 11 when the second oxide semiconductor material includes an IZO-based oxide semiconductor material having an In concentration of 50% or more relative to a total concentration of In and Zn, the ratio of In and Zn is between 5:5 to 7:3 and preferably wherein the ratio is 5:5, 6:4, or 7:3.
13. The display apparatus of any one of clauses 3 to 12 wherein the first sub-oxide semiconductor layer has at least one of a (400) crystal plane, a (222) crystal plane, a (220) crystal plane, a (311) crystal plane, and a (0016) crystal plane.
14 The display apparatus of any of clauses 5 to 13 wherein the ratio of the third crystal grains in the second sub-oxide semiconductor layer (132) is higher than the ratio of the second crystal grains in the second oxide semiconductor layer (230).
15 The display apparatus of clause 14 wherein the second sub-oxide semiconductor layer has a ratio of the third crystal grains having a particle size of 1 nm or more in a cross-sectional image of 5% to 10% of the total cross-sectional area of the second sub-oxide semiconductor layer.
16. The display apparatus of any preceding clause wherein the first oxide semiconductor layer includes a dopant doped into the oxide semiconductor material, the dopant includes at least one of beryllium (Be), boron (B), carbon (C), aluminum (Al), silicon (Si), iron (Fe), calcium (Ca), tin (Sn), titanium (Ti), tantalum (Ta), vanadium (V), yttrium (Y), zirconium (Zr), hafnium (Hf), lanthanum (La), and germanium (Ge).
17. The display apparatus of clause 16 wherein the first oxide semiconductor layer 130 is formed of an IGO (InGaO)-based oxide semiconductor material.
18. The display apparatus of clause 16, further including a gate driver having a plurality of stages each driving one of a plurality of gate lines and pixel driving circuit,
   wherein each of the plurality of stages includes an output unit including a pull-up transistor supplying a clock signal as an output voltage in response to the control of a first node,
   wherein the first thin film transistor is the pull-up transistor, and the second thin film transistor is included in the gate driver or the pixel driving circuit.
19. A method for manufacturing a display apparatus comprising steps of:
   preparing a base substrate disposed in a first region and a second region;
   forming a first oxide semiconductor layer on the base substrate disposed in the first region and forming a second oxide semiconductor layer on the base substrate disposed in the second region; and
   forming a first gate electrode and a second gate electrode to overlap the first oxide semiconductor layer and the second oxide semiconductor layer, respectively,
   wherein the step of forming the first oxide semiconductor layer and the second oxide semiconductor layer comprises steps of:
      forming an oxide semiconductor material layer on the base substrate;
      selectively irradiating the oxide semiconductor material layer disposed in the first region with a laser to crystallize the oxide semiconductor material layer disposed in the first region;
      forming a photoresist material layer on the oxide semiconductor material layer; and
      wet-etching the oxide semiconductor material layer using the photoresist material layer,
      wherein the first oxide semiconductor layer includes a first sub-oxide semiconductor layer having a crystalline structure, and
      wherein the second oxide semiconductor layer has a first amorphous structure.
20. The method for manufacturing a display apparatus of clause 19, wherein the oxide semiconductor material layer disposed in the second region is not irradiated by the laser.
21. The method for manufacturing a display apparatus of clause 19 or 20, wherein the crystalline structure has first crystal grains having a grain size of 1 nm or more in a cross-sectional image,
   wherein the first amorphous structure has second crystal grains having a grain size of 1 nm or more in a cross-sectional image,
   wherein a proportion of the first crystal grains is 50% or more of a total cross-sectional area of the first sub-oxide semiconductor layer, and
   wherein a proportion of the second crystal grains is 3% or less of a total cross-sectional area of the second oxide semiconductor layer.
22. The method for manufacturing a display apparatus of one of clauses 19 to 21, wherein the oxide semiconductor material layer is made of a first oxide semiconductor material,
   when a mobility of the first oxide semiconductor material is 10 cm²/Vs or less, the first oxide semiconductor layer further includes a second sub-oxide semiconductor layer,
   wherein the first sub-oxide semiconductor layer is disposed on the second sub-oxide semiconductor layer, and
   wherein the second sub-oxide semiconductor layer has a second amorphous structure different from the first amorphous structure.
23. The method for manufacturing a display apparatus of clause 22, wherein the second amorphous structure has third crystal grains having a grain size of 1 nm or more in a cross-sectional image, and
   wherein a proportion of the third crystal grains is 5% to 20% of a total cross-sectional area of the second sub-oxide semiconductor layer.
24. The method for manufacturing a display apparatus of any one of clauses 19 to 23, wherein the oxide semiconductor material layer is formed of a second oxide semiconductor material, and
   when a mobility of the second oxide semiconductor material exceeds 10 cm²/Vs, the first oxide semiconductor layer is formed of the crystalline structure.

## Claims

1. A display apparatus (1000) including a thin film transistor substrate, the thin film transistor substrate (100) comprising:
a base substrate (110); and
a first thin film transistor (TR11) and a second thin film transistor (TR12) disposed on the base substrate and spaced apart from each other,
wherein the first thin film transistor includes:
a first oxide semiconductor layer (130); and
a first gate electrode (150) overlapping the first oxide semiconductor layer, and
the second thin film transistor includes:
a second oxide semiconductor layer (230); and
a second gate electrode (250) overlapping the second oxide semiconductor layer,
wherein the first oxide semiconductor layer includes a first sub-oxide semiconductor layer (131) having a crystalline structure, and
wherein the second oxide semiconductor layer has a first amorphous structure.

2. The display apparatus of claim 1, wherein the crystalline structure has first crystal grains having a grain size of 1 nm or more in a cross-sectional image,
wherein the first amorphous structure has second crystal grains having a grain size of 1 nm or more in a cross-sectional image,
wherein a proportion of the first crystal grains is 50% or more of a total cross-sectional area of the first sub-oxide semiconductor layer, and
wherein a proportion of the second crystal grains is 3% or less of a total cross-sectional area of the second oxide semiconductor layer.

3. The display apparatus of claim 1 or 2, wherein the first oxide semiconductor layer is made of a first oxide semiconductor material,
wherein the first oxide semiconductor layer further includes a second sub-oxide semiconductor layer (132),
wherein the first sub-oxide semiconductor layer is disposed on the second sub-oxide semiconductor layer, and
wherein the second sub-oxide semiconductor layer has a second amorphous structure different from the first amorphous structure; and optionally
wherein the first sub-oxide semiconductor layer (131) and the second sub-oxide semiconductor layer (132) are made of the same material, and a thickness of the first sub-oxide semiconductor layer is greater than or equal to the thickness of the second sub-oxide semiconductor layer.

4. The display apparatus of claim 3, wherein the second amorphous structure has third crystal grains having a grain size of 1 nm or more in a cross-sectional image, and a proportion of the third crystal grains is 5% to 20% of a total cross-sectional area of the second sub-oxide semiconductor layer.

5. The display apparatus of any preceding claim, wherein the first oxide semiconductor layer (130) is formed of a second oxide semiconductor material, and the first oxide semiconductor layer is formed of a crystalline structure, and optionally wherein the first oxide semiconductor layer is a single-layer.

6. The display apparatus of any one of claims 3 to 6, wherein a mobility of the first oxide semiconductor material is 10 cm²/Vs or less.

7. The display apparatus of claim 6, wherein the first oxide semiconductor material includes at least one of an IZO-based oxide semiconductor material having an In concentration of less than 50% relative to a total concentration of In and Zn on an atomic basis, an IGZO-based oxide semiconductor material having an In concentration of less than 33% relative to a total concentration of In, Ga, and Zn, an IGZTO-based oxide semiconductor material having a sum of concentrations of In and Sn of less than 45% relative to a total concentration of In, Ga, Zn, and Sn, a GZTO-based oxide semiconductor material, and a GZO-based oxide semiconductor material; and optionally
when the first oxide semiconductor material includes an IZO-based oxide semiconductor material having an In concentration of less than 50% relative to a total concentration of In and Zn on an atomic basis, the ratio of In and Zn is between 2:8 to 4:6 and preferably wherein the ratio is 4:6, 3:7, or 2:8.

8. The display apparatus of any of claims 5 to 7, wherein a mobility of the second oxide semiconductor material exceeds 10 cm²/Vs.

9. The display apparatus of claim 8, wherein the second oxide semiconductor material includes at least one of an IZO-based oxide semiconductor material having an In concentration of 50% or more relative to a total concentration of In and Zn, an IGO-based oxide semiconductor material having an In concentration of 70% or more relative to a total concentration of In and Ga, an IGZO-based oxide semiconductor material having an In concentration of 33% or more relative to a total concentration of In, Ga, and Zn, an ITO-based oxide semiconductor material having an In concentration of 80% or more relative to a total concentration of In and Sn, an IGZTO-based oxide semiconductor material having a sum of concentrations of In and Sn of 45% or more relative to a total concentration of In, Ga, Zn, and Sn, and an ITZO-based oxide semiconductor material having a sum of concentrations of In and Sn of 45% or more relative to a total concentration of In, Sn, and Zn; and optionally
when the second oxide semiconductor material includes an IZO-based oxide semiconductor material having an In concentration of 50% or more relative to a total concentration of In and Zn, the ratio of In and Zn is between 5:5 to 7:3 and preferably wherein the ratio is 5:5, 6:4, or 7:3.

10. The display apparatus of any one of claims 3 to 9 wherein the first sub-oxide semiconductor layer has at least one of a (400) crystal plane, a (222) crystal plane, a (220) crystal plane, a (311) crystal plane, and a (0016) crystal plane.

11. The display apparatus of any of claims 4 to 10 wherein the ratio of the third crystal grains in the second sub-oxide semiconductor layer (132) is higher than the ratio of the second crystal grains in the second oxide semiconductor layer (230); and optionally
wherein the second sub-oxide semiconductor layer has a ratio of the third crystal grains having a particle size of 1 nm or more in a cross-sectional image of 5% to 10% of the total cross-sectional area of the second sub-oxide semiconductor layer.

12. The display apparatus of any preceding claim, further including a gate driver having a plurality of stages each driving one of a plurality of gate lines and pixel driving circuit,
wherein each of the plurality of stages includes an output unit including a pull-up transistor supplying a clock signal as an output voltage in response to the control of a first node,
wherein the first thin film transistor is the pull-up transistor, and the second thin film transistor is included in the gate driver or the pixel driving circuit.

13. A method for manufacturing a display apparatus comprising steps of:
preparing a base substrate (110) disposed in a first region and a second region;
forming a first oxide semiconductor layer (130) on the base substrate disposed in the first region and forming a second oxide semiconductor layer (230) on the base substrate disposed in the second region; and
forming a first gate electrode (150) and a second gate electrode (250) to overlap the first oxide semiconductor layer and the second oxide semiconductor layer, respectively,
wherein the step of forming the first oxide semiconductor layer and the second oxide semiconductor layer comprises steps of:
forming an oxide semiconductor material layer on the base substrate;
selectively irradiating the oxide semiconductor material layer disposed in the first region with a laser to crystallize the oxide semiconductor material layer disposed in the first region;
forming a photoresist material layer on the oxide semiconductor material layer; and
wet-etching the oxide semiconductor material layer using the photoresist material layer,
wherein the first oxide semiconductor layer includes a first sub-oxide semiconductor layer (131) having a crystalline structure,
wherein the second oxide semiconductor layer has a first amorphous structure; and wherein the oxide semiconductor material layer disposed in the second region is not irradiated by the laser.

14. The method for manufacturing a display apparatus of claim 13, wherein the crystalline structure has first crystal grains having a grain size of 1 nm or more in a cross-sectional image,
wherein the first amorphous structure has second crystal grains having a grain size of 1 nm or more in a cross-sectional image,
wherein a proportion of the first crystal grains is 50% or more of a total cross-sectional area of the first sub-oxide semiconductor layer, and
wherein a proportion of the second crystal grains is 3% or less of a total cross-sectional area of the second oxide semiconductor layer.

15. The method for manufacturing a display apparatus of claims 13 or 14, wherein the oxide semiconductor material layer is made of a first oxide semiconductor material,
when a mobility of the first oxide semiconductor material is 10 cm²/Vs or less, the first oxide semiconductor layer further includes a second sub-oxide semiconductor layer,
wherein the first sub-oxide semiconductor layer is disposed on the second sub-oxide semiconductor layer, and
wherein the second sub-oxide semiconductor layer has a second amorphous structure different from the first amorphous structure; and optionally wherein
the second amorphous structure has third crystal grains having a grain size of 1 nm or more in a cross-sectional image, and
wherein a proportion of the third crystal grains is 5% to 20% of a total cross-sectional area of the second sub-oxide semiconductor layer; and optionally wherein
the method wherein the oxide semiconductor material layer is formed of a second oxide semiconductor material, and
when a mobility of the second oxide semiconductor material exceeds 10 cm²/Vs, the first oxide semiconductor layer is formed of the crystalline structure.
